Europäisches Patentamt

European Patent Office

Office européen des brevets

(11) Numéro de publication: **0 337 233**
**A2**

## (12) DEMANDE DE BREVET EUROPEEN

(21) Numéro de dépôt: **89105804.2**

(22) Date de dépôt: **03.04.89**

(51) Int. Cl.4: **G01R 25/00**

(30) Priorité: **11.04.88 FR 8804754**

(43) Date de publication de la demande:
**18.10.89 Bulletin 89/42**

(84) Etats contractants désignés:
**CH DE ES FR IT LI SE**

(71) Demandeur: **PSC PROTECTIONS ET SYSTEMES DE CONTROLE**
**50, avenue Jean-Jaurès**
**F-92120 Montrouge(FR)**

(72) Inventeur: **Asfaux, Raymond**
**9, rue Phelypeaux**
**F-78640 Neauphle le Chateau(FR)**

(74) Mandataire: **Weinmiller, Jürgen et al**
**Lennéstrasse 9 Postfach 24**
**D-8133 Feldafing(DE)**

(54) **Indicateur de la différence de phase de composantes sinusoidales de deux signaux eventuellement deformes par un filtrage non lineaire.**

(57) Le dispositif (5) permet une détection de la différence de phase de composantes sinusoïdales de signaux primaires (VP,IP) à partir de signaux secondaires altérés (F(V,I), G(V,I)).

Il comprend des moyens de multiplication fournissant le produit des signaux secondaires et du sinus de leur angle de déphasage.

FIG.1

# INDICATEUR DE LA DIFFERENCE DE PHASE DE COMPOSANTES SINUSOIDALES DE DEUX SIGNAUX EVENTUELLEMENT DEFORMES PAR UN FILTRAGE NON LINEAIRE.

La présente invention concerne un dispositif de détection propre à fournir un signal de sortie fonction de la différence entre les phases respectives de composantes sinusoïdales de même fréquence de deux signaux électriques primaires, ce dispositif utilisant deux signaux d'entrée dépendants de signaux secondaires dont l'un au moins résulte d'un éventuel filtrage non linéaire d'un desdits signaux primaires.

La détection de la différence de phase que présentent entre eux deux signaux sinusoïdaux purs est un problème classique, pour la solution duquel l'homme du métier dispose, dans l'art antérieur, d'innombrables techniques immédiatement susceptibles d'être mises en oeuvre.

La plus connue consiste à utiliser un circuit logique électronique recevant, en tant que signaux d'entrée, les deux signaux sinusoïdaux, et fournissant un signal de sortie représentatif de la polarité de l'un quelconque de ces deux signaux à l'instant où l'autre passe de l'alternance négative à l'alternance positive. Si cette polarité est positive, le signal passant par zéro est en retard de phase; si elle est négative, le signal passant par zéro est en avance de phase. De plus, la durée pendant laquelle le signal repéré par son passage par zéro reste positif alors que l'autre reste négatif représente, par rapport à la période commune des deux signaux, la valeur de leur différence de phase.

L'utilisation de tels circuits de détection est courante dans les relais de protection de réseaux électriques, que ce soit pour rechercher la direction de l'origine d'un défaut, sa distance par rapport au point d'implantation du relais, ou pour identifier, dans un ensemble de conducteurs électriques, celui qui est le siège d'un défaut.

Par exemple, les procédés décrits dans les brevets américains US 3 369 156, US 3 626 281, et US 4 325 098 comprennent des opérations de comparaison de phase qui sont susceptibles d'être effectuées par des circuits de ce type.

Le recours à cette technique suppose cependant que les signaux d'entrée de ces cicuits de détection soient sinusoïdaux, ou dérivent d'une représentation fidèle des signaux primaires à composante sinusoïdale dont la différence de phase intervient.

Or, cette condition n'est pas remplie lorsque, par exemple, les signaux d'entrée sont fonctions de signaux secondaires dont l'un au moins résulte d'un filtrage non linéaire d'un signal primaire à composante apériodique.

Tel est le cas en particulier lorsque l'un au moins des signaux d'entrée est constitué par le signal secondaire d'un transformateur alimenté par un courant primaire qui, outre une composante sinusoïdale, comporte une composante apériodique telle que ce transformateur se trouve dans un état de saturation et produit en conséquence un signal secondaire déformé par un filtrage non linéaire du signal primaire.

Dans de tels cas, les circuits de détection classiques décrits ci-dessus conduisent à des résultats totalement erronés, de sorte que leur emploi est notamment proscrit, en l'absence de précautions particulières, dans les relais de protection de réseaux électriques recevant des signaux issus d'un transformateur saturable.

A ce jour, le principe mis en oeuvre, pour tenir compte des limitations des techniques connues de détection de déphasage dans leur application aux relais de protection, repose sur le fait que le signal secondaire d'un transformateur de courant en état de saturation garde une forme correcte sur une partie de sa période; plus précisément, ce signal reste correct au voisinage d'un de ses passages à zéro, comme cela est exposé dans le brevet US 3 714 545, qui enseigne en outre la façon de sélectionner ce passage par zéro.

Dans la mesure où l'exploitation du signal secondaire déformé se réduit à observer son avance ou son retard de phase, une possibilité consiste à ne procéder à cette observation qu'au voisinage de ses passages à zéro corrects. Cette solution élimine cependant la possibilité de vérifier la valeur du déphasage observée à un passage à zéro du signal secondaire par l'observation de cette valeur au passage à zéro immédiatement suivant, puisque le signal secondaire n'est correct qu'au voisinage de l'un seulement de deux passages à zéro consécutifs. Cette impossibilité a donc pour résultat d'augmenter les temps d'observation nécessaires, d'une façon qui dépend de la confiance qu'il est possible d'accorder à chacune des informations recueillies, aux passages à zéro corrects du signal secondaire, sur le signe du déphasage observé.

Après avoir sélectionné, conformément à l'enseignement du brevet US 3 714 545, les passages à zéro corrects du signal secondaire du transformateur, il est également possible, comme le montre le brevet EP 90 095, de reconstituer un signal, supposé donner l'image du signal primaire du transformateur, que ce dernier a déformé par un filtrage non linéaire résultant de son état de saturation.

Une telle approche conduit cependant à concevoir des systèmes relativement complexes, donc coûteux et posant eux-mêmes des problèmes de fiabilité.

Dans ce contexte, le but de la présente invention est de proposer un dispositif simple, prenant la forme d'un circuit électronique ou d'un circuit de traitement de données programmé, permettant au moins de déterminer, de façon fiable et rapide, le signe de la différence de phase des composantes sinusoïdales de deux signaux dont l'un au moins n'est connu que par l'intermédiaire d'un signal secondaire résultant d'un filtrage non-linéaire d'un signal primaire.

A cette fin, le dispositif de l'invention est essentiellement caractérisé en ce qu'il comprend des moyens de multiplication propres à fournir un signal intermédiaire lié au produit des deux signaux fournis à l'entrée de ce dispositif, et un organe de sortie propre à recevoir ledit signal intermédiaire et à délivrer, en tant que signal de sortie du dispositif, un signal lié au moins à la polarité de ce signal intermédiaire.

Dans une forme avantageuse de réalisation de l'invention, les moyens de multiplication comprennent d'une part des première et seconde entrées recevant respectivement les premiers et second signaux d'entrée, d'autre part deux voies de traitement reliées aux première et seconde entrées et incluant elles-mêmes deux multiplieurs respectifs et deux déphaseurs, et d'autre part encore un sommateur; chaque multiplieur a deux entrées respectivement reliées auxdites première et seconde entrées; lesdits déphaseurs, qui déphasent de préférence de 90 degrés, sont respectivement reliés auxdites première et seconde entrées en amont desdits multiplieurs, et le sommateur reçoit les signaux de sortie des deux multiplieurs pour produire ledit signal intermédiaire.

En variante, les moyens de multiplication peuvent simplement comprendre un déphaseur recevant l'un des signaux d'entrée et un multiplieur recevant l'autre signal d'entrée et le signal de sortie du déphaseur.

L'organe de sortie comprend avantageusement un intégrateur ou un filtre passe-bas.

le dispositif suivant l'invention est principalement applicable à la détection du signe de la phase relative des composantes sinusoïdales de deux signaux électriques primaires ou de deux de leurs combinaisons linéaires dans des relais utilisant deux signaux d'entrée dont l'un au moins est au moins partiellement constitué par le signal de sortie d'un transformateur de courant saturable.

Les caractéristiques du relais dépendent bien sûr, comme cela est connu de l'homme de l'art, de la nature des signaux dont la différence de phase est détectée. Ces signaux seront donc choisis en fonction de la finalité du relais dans lequel est utilisé le dispositif de l'invention.

Par exemple, un relais directionnel utilise la comparaison des phases relatives d'un signal U issu du secondaire d'un transformateur de tension et supposé représenter la tension de la ligne électrique protégée, et d'un signal Z.I élaboré à partir d'une part d'un signal I présent au secondaire d'un transformateur de courant, supposé représenter le courant dans la ligne électrique protégée, et d'autre part d'une grandeur Z représentative d'une impédance de la ligne: s'il est utilisé dans un tel relais, le dispositif de l'invention reçevra donc, en tant que signaux d'entrée, les grandeurs U et Z.I; un relais de réactance utilise la comparaison des phases relatives d'un signal U-X.I constitué par une combinaison linéaire des signaux de tension et de courant, et d'un signal X.I fonction du courant I: s'il est utilisé dans un tel relais, le dispositif de l'invention recevra donc, en tant que signaux d'entrée, les grandeurs U-X.I et X.I, etc.

D'autres caractéristiques et avantages de l'invention ressortiront clairement de la description qui en est faite ci-après, à titre indicatif et nullement limitatif, en référence aux dessins annexés, parmi lesquels:

- la figure 1 est un schéma général, illustrant le contexte d'application préférentiel du dispositif de l'invention;
- la figure 2 est un schéma d'un premier mode de réalisation de l'invention;
- la figure 3 est un schéma d'un second mode de réalisation de l'invention;
- la figure 4 est un schéma d'un troisième mode de réalisation de l'invention;
- la figure 5 illustre, en fonction du temps, l'allure d'un signal de courant primaire reçu par un transformateur saturable, et l'allure d'un signal de courant secondaire produit par ce dernier;
- la figure 6 représente à nouveau le signal de courant secondaire, et la dérivée de ce signal;
- la figure 7 représente un signal de tension et un signal combiné, obtenu comme une fonction du signal de tension et de la dérivée du signal de courant secondaire;
- la figure 8 représente le signal de sortie d'un dispositif proche de celui de la figure 3; et
- la figure 9 représente encore un autre mode de réalisation de l'invention.

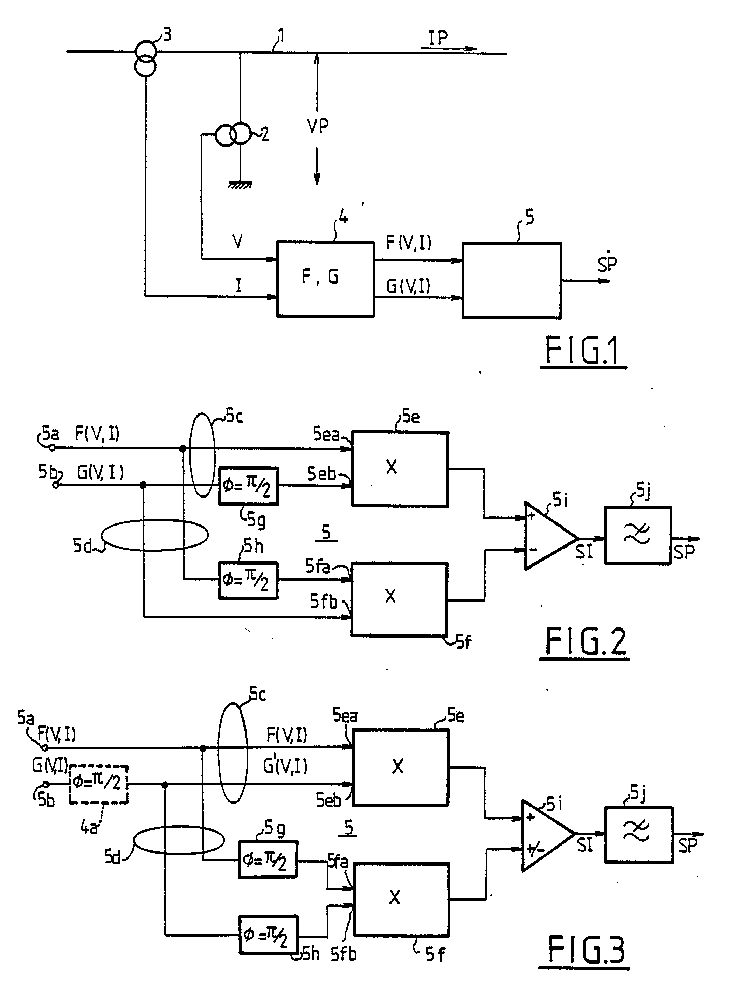

La figure 1 représente une ligne électrique 1, à laquelle sont associés un transformateur de tension 2, fournissant un signal V représentatif du potentiel VP de cette ligne, et un transformateur de courant 3, fournissant un signal I représentatif du courant IP circulant sur cette ligne.

En régime normal, les signaux primaires que constituent le potentiel VP de la ligne et le courant IP que celle-ci transporte sont les fonctions sinusoïdales du temps, de même que les signaux secondaires V et I qui en constituent les images.

Dans la mesure où la protection de la ligne électrique 1 est obtenue par comparaison des phases respectives non pas des deux signaux VP et IP directement, mais de deux combinaisons différentes F(V,I) et G(V,I) des signaux secondaires V et I, il est prévu un circuit de traitement 4 dont la fonction est précisément de fournir les signaux F-(V,I) et G(V,I) à partir des signaux secondaires V et I.

Ces circuits de traitement, bien connus de l'homme de l'art et utilisés dans tous les relais antérieurs, sont susceptibles d'effectuer, de façon analogique ou numérique, des opérations de tout type, par exemple des dérivations, des intégrations, des combinaisons linéaires, etc.

Conformément à l'invention, la comparaison des phases des signaux F(V,I) et G(V,I) est obtenue grâce à un dispositif 5 qui reçoit ces derniers en tant que signaux d'entrée et qui produit un signal de sortie fonction de leur différence de phase, même dans les conditions de fonctionnement très défavorables qui peuvent apparaître lorsque, précisément, le dispositif de l'invention doit remplir la fonction qui lui est assignée.

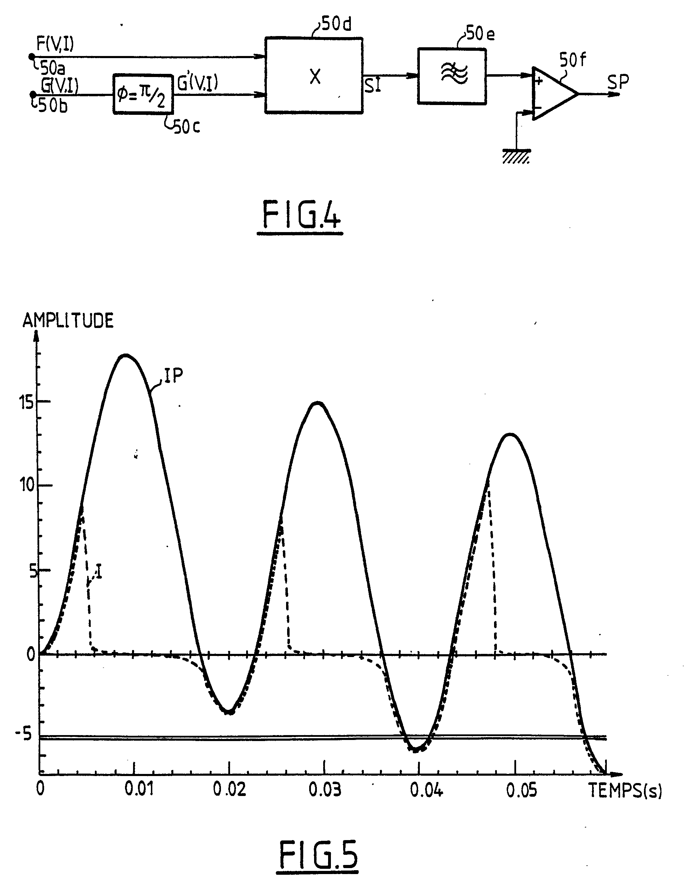

En effet, alors que les signaux primaire IP et secondaire I sont des fonctions sinusoïdales du temps dans les conditions normales d'exploitation de la ligne électrique 1, le signal IP peut, en cas de défaut sur la ligne, présenter une composante apériodique importante (voir la figure 5) qui entraîne elle-même une déformation considérable du signal I par rapport au signal IP.

Non seulement les signaux IP et I ne sont plus alors strictement périodiques, mais la composante périodique de plus basse fréquence du signal I est en outre affectée.

Dans ces conditions, même la notion de différence de phases entre deux signaux est affectée puisque celle-ci n'est applicable qu'à des signaux périodiques de même fréquence. Néanmoins le dispositif de l'invention permet l'évaluation de la différence de phase que présenteraient entre eux les deux signaux qu'il reçoit s'ils n'avaient pas été déformés.

Selon les premier et second modes de réalisation (figures 2 et 3) le dispositif comprend : des première et seconde entrées 5a, 5b, recevant les premier et second signaux d'entrée F(V,I) et G(V,I); deux voies de traitement 5c, 5d reliées aux deux entrées et incluant elles-mêmes deux multiplieurs respectifs 5e, 5f et deux déphaseurs 5g, 5h; un sommateur 5i, recevant les signaux de sortie des multiplieurs et produisant un signal intermédiaire SI; et un organe de sortie 5j, comprenant un filtre passe-bas, et produisant le signal de sortie SP.

Chaque multiplieur 5e, 5f a deux entrées 5ea, 5eb, 5fa, 5fb respectivement reliées aux entrées 5a, 5b.

Les déphaseurs 5g, 5h, qui opèrent de préférence un déphasage de 90 degrés sur tout signal sinusoïdal dont la fréquence est la fréquence normale des signaux primaires VP et IP, sont respectivement reliés aux première et seconde entrées 5a, 5b; ils sont en outre montés en amont des multiplieurs, c'est-à-dire, en d'autres termes, qu'aucun d'eux n'est monté en aval d'un multiplieur.

Le sommateur 5i élabore le signal intermédiaire SI en formant la différence des signaux de sortie des multiplieurs qu'il reçoit sur ses entrées.

Le filtre passe-bas qui constitue, ou que comprend, l'organe de sortie 5j a une fréquence de coupure inférieure à la fréquence normale des signaux primaires VP et IP, et est par exemple constitué par un filtre de Bessel d'ordre au moins égal à 2.

Dans le mode de réalisation de la figure 2, le dispositif de l'invention permet une évaluation de la différence de phase entre les signaux F(V,I) et G-(V,I), ou au moins du signe de cette différence.

En régime normal, F(V,I) et G(V,I) sont des signaux sinusoïdaux de même période que les signaux VP et IP et liés à ces derniers par des relations de phase dépendant de la nature des combinaisons F et G. Dans ces conditions, le signal SI est proportionnel à $\|F(V,I)\|.\|G(V,I)\|.\sin(phi)$ où $\|F(V,I)\|$ et $\|G(V,I)\|$ sont les amplitudes extrêmes respectives des signaux F(V,I) et G(V,I) et où (phi) représente la différence de phase de ces signaux.

En cas de saturation du transformateur 3, ces relations disparaissent, puisque le signal I n'est plus ni véritablement périodique ni d'allure sinusoïdale. Néanmoins, même dans ces conditions, comme l'inventeur a eu le mérite de le découvrir, le signal SI reste représentatif par sa polarité, et approximativement au moins par son amplitude, respectivement du signe et de la valeur de l'angle (phi).

La figure 3 illustre un taure mode de réalisation, fonctionnellement identique à celui de la figure 2, mais présentant une différence de structure apparente.

Dans ce mode de réalisation, les déphaseurs 5g et 5h sont montés en amont du même multiplieur 5f, au lieu d'être branchés sur les entrées respectives 5eb et 5fa des multiplieurs 5e et 5f. De plus, le sommateur 5i réalise une somme des signaux de sortie des multiplieurs et non une différence.

Ces différences de structure s'expliquent par l'existence d'un déphaseur 4a, par exemple intégré au circuit de traitement 4; ainsi, le déphaseur 4a, le déphaseur 5h branché sur l'entrée 5fb, et le changement de signe du signal de sortie du multiplieur 5f remplissent, comme le percevra aisément l'homme de l'art, la même fonction que le déphaseur 5g de la figure 2, les déphaseurs 4a et 5h de la figure 3 étant équivalents à une inversion de signe.

Bien entendu, comme le comprendra également l'homme de l'art, l'inversion de signe peut être effectuée sur l'un des déphaseurs 4a, 5h de la figure 3 au lieu de l'être sur le sommateur 5i.

Par exemple, l'un des déphaseurs peut être constitué par un dérivateur et l'autre par un intégrateur; plus généralement, l'un de ces déphaseurs peut introduire une avance de phase de 90° et l'autre un retard de phase de 90°.

La figure 4 représente un troisième mode de réalisation de l'invention.

Les signaux F(V,I) et G(V,I) parviennent aux entrées 50a, 50b, du dispositif.

Le signal G'(V,I), obtenu par un déphasage de 90° du signal G(V,I) au moyen du déphaseur 50c, et le signal F(V,I) sont fournis aux entrées d'un multiplieur 50d.

Ce dernier délivre un signal intermédiaire SI à un organe de sortie comprenant au moins un intégrateur ou un filtre passe-bas ou un filtre à encoche 50e, et un comparateur 50f en série.

L'intégrateur ou le filtre 50e est par exemple constitué par un filtre de Bessel d'ordre 6 ayant une fréquence de coupure inférieure à la fréquence normale des signaux VP et IP.

Le comparateur 50f compare à zéro le signal de sortie du filtre 50e et délivre un signal de sortie SP représentatif de la polarité du signal de sortie du filtre.

Ce troisième mode de réalisation, bien que ne fournissant en pratique que le signe de la différence de phase des signaux F(V,I) et G(V,I) présente l'avantage d'une grande simplicité de structure.

La figure 5 représente l'évolution, au cours du temps, de l'amplitude d'un signal primaire IP constitué par une composante sinusoïdale à laquelle se superpose un courant apériodique. I représente le signal de courant secondaire du transformateur 3 en état de saturation.

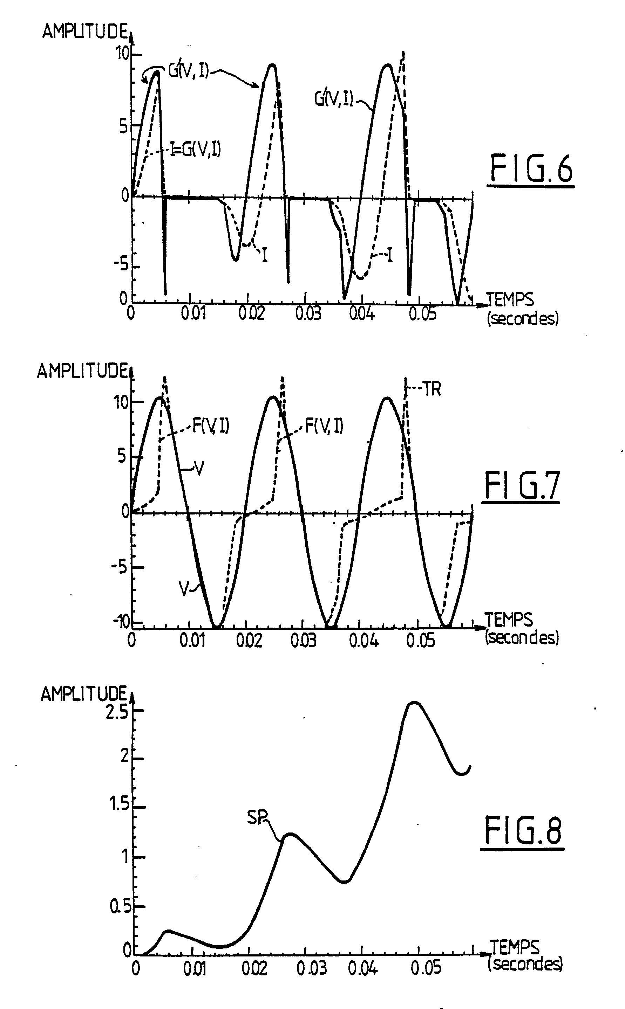

La figure 6 représente à nouveau le signal I, et un signal G'(V,I) constitué en fait par le signal de sortie d'un déphaseur 4a tel que celui de la figure 3 dans le cas où G(V,I) est simplement égal à I et où ce déphaseur 4a est un simple dérivateur.

La figure 7 représente d'une part le signal secondaire V de sortie du transformateur de tension 2 et d'autre part un signal F(V,I). Ce dernier est constitué par la combinaison linéaire V-L.dI/dt, dans laquelle dI/dt est la dérivée du courant I, c'est-à-dire encore, en l'occurence, G'(V,I), et dans laquelle L est une inductance.

Ces différents signaux F(V,I) = V-L.dI/dt et G-(V,I) = I sont traités par un dispositif conforme à celui de la figure 3, mais dans lequel les déphaseurs 4a et 5g sont des dérivateurs, dans lequel le déphaseur 5h est un intégrateur, et dans lequel le sommateur 5i effectue une différence des signaux appliqués à son entrée.

Dans ces conditions, et dans un cas limite de détection, le signal de sortie SP du dispositif est celui qui est donné sur la figure 8 : la valeur et le signe de ce signal sont corrélés à la valeur et au signe de la différence de phase entre les composantes périodiques des signaux VP-L.d(IP)/dt et IP.

De même que les déphaseurs 5g, 5h, 50c peuvent être réalisés de différentes façons, par exemple sous la forme de filtres de Hilbert, de dérivateurs ou d'intégrateurs, de même les multiplieurs et autres composants du dispositif de l'invention peuvent prendre des formes diverses et, par exemple, être constitués soit par des circuits électroniques analogiques, soit par des opérations d'une unité de traitement numérique convenablement programmée.

Grâce à sa fiabilité, le dispositif de l'invention garde tout son intérêt même lorsqu'il est utilisé en combinaison avec un sélecteur de passages à zéro de l'art antérieur, tel que celui décrit dans le brevet US 3 714 545.

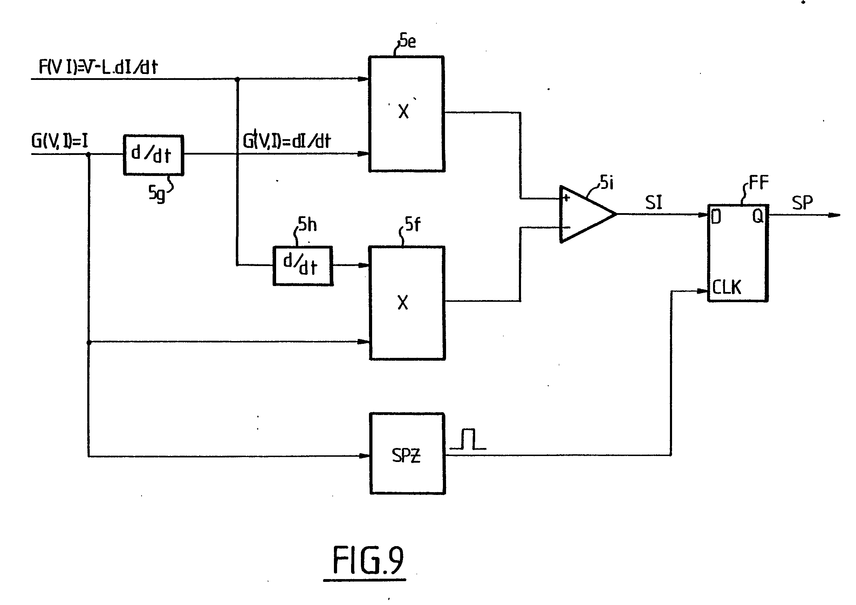

En effet, comme le montre la figure 7, le signal F(V,I) peut présenter des pics transitoires TR élevés qui sont susceptibles, si leur énergie est trop importante, de ralentir l'évolution du signal de sortie SP. Si un tel risque existe, il peut être avantageux d'utiliser le dispositif de l'invention en l'associant à un sélecteur de passages à zéro SPZ, comme représenté sur la figure 9.

Ce dernier, recevant le signal G(V,I), sélectionne ceux des passages à zéro de ce signal qui correspondent à un signal non perturbé, comme l'enseigne le brevet US 3 714 545. Le signal de sortie de ce sélecteur, constitué par une impulsion apparaissant à l'instant de chaque passage à zéro correct du signal G(V,I), est appliqué sur l'entrée d'horloge CLK d'une bascule FF dont l'entrée D reçoit le signal SI élaboré comme précédemment décrit. La bascule FF produit sur sa sortie Q un signal SP représentatif de la polarité du signal SI au dernier passage à zéro correct du signal G(V,I).

## Revendications

1. Dispositif de détection propre à fournir un signal de sortie fonction de la différence entre les phases respectives de composantes sinusoïdales de même fréquence de deux signaux électriques primaires (VP, IP), ce dispositif utilisant deux signaux d'entrée F(V,I), G(V,I)) dépendants de signaux secondaires (V,I) dont l'un au moins résulte d'un éventuel filtrage non linéaire d'un desdits signaux primaires, caractérisé en ce qu'il comprend des moyens de multiplication (5e, 5f, 5i, 50d) propres à fournir un signal intermédiaire (SI) lié au produit des deux signaux d'entrée, et un organe de sortie (5j, 50e, 50f, FF) propre à recevoir ledit signal intermédiaire et à fournir, en tant que signal de sortie (SP) du dispositif, un signal lié au moins à la polarité de ce signal intermédiaire.

2. Dispositif suivant la revendication 1, caractérisé en ce que lesdits moyens de multiplication comprennent d'une part des première et seconde entrées (5a, 5b) recevant respectivement les premiers et second signaux d'entrée, d'autre part deux voies de traitement (5c, 5d) reliées aux première et seconde entrées et incluant elles-mêmes deux multiplieurs (5e, 5f) respectifs et deux déphaseurs (5g, 5h), et d'autre part encore un sommateur (5i), en ce que chaque multiplieur a deux entrées respectivement reliées auxdites première et seconde entrées, en ce que lesdits déphaseurs sont respectivement reliés auxdites première et seconde entrées en amont desdits multiplieurs, et en ce que le sommateur reçoit les signaux de sortie des deux multiplieurs pour produire ledit signal intermédiaire.

3. Dispositif suivant la revendication 2, caractérisé en ce que chacun desdits déphaseurs opère sur les signaux qu'il reçoit un déphasage de 90 degrés.

4. Dispositif suivant la revendication 1, caractérisé en ce que lesdits moyens de multiplication comprennent un déphaseur (50c) recevant l'un des signaux d'entrée et un multiplieur (50d) recevant l'autre signal d'entrée et le signal de sortie du déphaseur.

5. Dispositif suivant l'une quelconque des revendications 1 à 4, caractérisé en ce que l'organe de sortie comprend un intégrateur.

6. Dispositif suivant l'une quelconque des revendications 1 à 4, caractérisé en ce que l'organe de sortie comprend un filtre passe-bas.

7. Application d'un dispositif suivant l'une quelconque des revendications précédentes à la détection du signe de la phase relative des composantes sinusoïdales de deux signaux électriques primaires ou de deux de leurs combinaisons linéaires, à partir de deux signaux d'entrée dont l'un au moins est au moins partiellement constitué par le signal de sortie d'un transformateur de courant saturable.

FIG.1

FIG.2

FIG.3

FIG.4

FIG.5

FIG.6

FIG.7

FIG.8

FIG.9